# EUROPEAN PATENT APPLICATION

(11) **EP 4 383 985 A1**
(43) Date of publication of application: **12.06.2024**
(21) Application number: 23213267.0
(22) Date of filing: 30.11.2023
(51) Int. Cl.: H10K 59/80, H10K 77/10

(54) **DISPLAY DEVICE**

(30) Priority: 05.12.2022 KR 20220168232
(71) Applicant: Samsung Display Co., Ltd., Yongin-si, Gyeonggi-do 17113 (KR)
(72) Inventor: SON, Jun Hee, 17113 Yongin-si (KR); PARK, Haeng Won, 17113 Yongin-si (KR); OH, Hyun Joon, 17113 Yongin-si (KR); LEE, Jee Na, 17113 Yongin-si (KR)
(74) Representative: Walaski, Jan Filip

(57) **Abstract**

A display device includes: a display panel including a first substrate having a pixel area; and a cover layer. A rear surface of the first substrate is bonded to a front surface of the cover layer, and a flow path pattern is formed in at least one of the rear surface of the first substrate and the front surface of the cover layer at a depth from a corresponding surface.

## Description

### CROSS-REFERENCE TO RELATED APPLICATION

This application claims priority to Korean Patent Application No. 10-2022-0168232, filed on December 05, 2022, in the Korean Intellectual Property Office.

### BACKGROUND

### 1. Field

Aspects of embodiments of the present disclosure relate to a display device.

### 2. Description of the Related Art

As the information-oriented society evolves, various demands for display devices are increasing. For example, display devices are being employed by (or implemented in) a variety of electronic devices, such as smart phones, digital cameras, laptop computers, navigation devices, monitors, and television sets. Display devices may be flat panel display devices, such as a liquid-crystal display device, a field emission display device, an organic light-emitting display device, and a quantum-dot light-emitting display device.

As such display devices are becoming thinner with higher performance, a heating dissipation issue has emerged as a serious problem.

### SUMMARY

There is a need for an effective scheme for reducing the overall temperature of display devices by solving the heat dissipation issue of the display devices.

Embodiments of the present disclosure provide a display device that exhibits a reduced overall temperature by solving the heat dissipation issue without substantially increasing the thickness of the display device.

However, aspects and features of the present disclosure are not limited to those set forth herein. The above and other aspects and features of the present disclosure will become more apparent to one of ordinary skill in the art to which the present disclosure pertains by referencing the detailed description of the present disclosure given below.

According to an embodiment, a display device includes: a display panel including a first substrate having a pixel area; and a cover layer. A rear surface of the first substrate is bonded to a front surface of the cover layer, and a flow path pattern is formed in at least one of the rear surface of the first substrate and the front surface of the cover layer at a depth from a corresponding surface.

A flow path formed by the flow path pattern may have a zigzag or spiral shape, and the flow path may have a single channel in a form of a closed loop.

The display device may further include a working fluid in the flow path.

A volume of the working fluid may be in a range from 30% to 60% of a volume of the flow path.

The working fluid may be water, ethanol, ammonia, acetone, R-134a, or an HFC-type fluid.

A cross section of the flow path may be a circular shape, an elliptical shape, or a polygonal shape.

The display device may further include: a flexible film attached to a front surface of the first substrate and bent toward a rear surface of the cover layer; and a driving circuit on the flexible film and arranged along one side of the rear surface of the cover layer.

The working fluid may be configured to absorbs heat dissipated from the driving circuit and to transfer the absorbed heat to an area away from the driving circuit along the flow path.

An end of the flow path overlapping with the driving circuit may act as an evaporator and an opposite end of the flow path may act as a condenser.

The flow path may include a horizontal portion extended in a first direction and a plurality of vertical portions extended in a second direction perpendicular to the first direction, and the horizontal portion may be in the condenser.

Protrusions may be formed on at least a part of an inner circumferential surface of the flow path.

The protrusions may be extended along a longitudinal direction of the flow path.

The display panel may further include a thin-film transistor layer, an emission material layer, and an encapsulation layer on the first substrate, and a light conversion layer and/or a color filter layer may be on the encapsulation layer.

According to another embodiment, a display device includes: a display panel including a first substrate having a pixel area; and a cover layer. A rear surface of the first substrate is bonded to a front surface of the cover layer, and the rear surface of the first substrate has a first flow path pattern.

The front surface of the cover layer may have a second flow path pattern corresponding to the first flow path pattern.

Protrusions may be formed on an inner surface of the second flow path pattern.

The protrusions may be extended along a longitudinal direction of the second flow path pattern.

According to another embodiment, a display device includes: a display panel including a first substrate having a pixel area; a cover layer facing a rear surface of the first substrate and bonded thereto; a flexible film adhered to a front surface of the first substrate and bent toward a rear surface of the cover layer; and a plurality of driving circuits on the flexible film and arranged in a first direction along one side of the rear surface of the cover layer. The rear surface of the first substrate and the front surface of the cover layer face each other and are bonded to each other, the rear surface of the first substrate has a first linear flow path pattern, and an end of the first linear flow path pattern that overlaps the driving circuits acts an evaporator while and an opposite end thereof acts as a condenser.

The display device may further include a working fluid in a linear flow path formed by the first and second linear flow path patterns.

The working fluid may be configured to absorb heat from the evaporator and to transfer the absorbed heat to the condenser along the linear flow path.

The front surface of the cover layer may have a second linear flow path pattern corresponding to the first linear flow path pattern.

Protrusions may be formed on an inner surface of the second linear flow path pattern.

According to embodiments of the present disclosure, the overall temperature of a display device can be lowered by connecting (e.g., thermally connecting) a high-temperature region with a low-temperature region by a pulsating heat pipe.

According to embodiments of the present disclosure, a thin display device may be implemented by way of forming such a heat pipe by patterning the substrate(s) of the display panel of a display device.

However, aspects and features of the present disclosure are not limited to the aforementioned aspects and features, and various other aspects and features are included in the present specification.

### BRIEF DESCRIPTION OF THE DRAWINGS

The above and other aspects and features of the present disclosure will become more apparent by describing, in detail, embodiments thereof with reference to the attached drawings, in which:
FIG. 1 is an exploded, perspective view of a display device according to an embodiment of the present invention.
FIG. 2 is a bottom view showing the upper surface of the display panel when the flexible films shown in FIG. 1 are unfolded.
FIG. 3 is an equivalent circuit diagram of a pixel of the display panel.
FIG. 4 shows a layout of a pixel.
FIG. 5 is a cross-sectional view taken along the line I - I' of FIG. 4.
FIG. 6 is a schematic cross-sectional view of an organic light-emitting diode included in a pixel PX.
FIGS. 7 to 9 illustrate how a pulsating heat pipe works.
FIG. 10 is a bottom view showing the lower surface of a display panel when the flexible films shown in FIG. 1 are unfolded.
FIG. 11 is an enlarged view of the part A of FIG. 10.
FIG. 12 is a cross-sectional view taken along the line B-B' of FIG. 11.
FIG. 13 is a bottom view showing the lower surface of the cover layer when the flexible films shown in FIG. 1 are bent under the cover layer.
FIG. 14 shows an example of a flow path having a plurality of evaporators.
FIG. 15 is a bottom view showing a first flow path pattern formed on the first substrate shown in FIG. 1.
FIG. 16 is a plan view of a second flow path pattern formed on the cover layer shown in FIG. 1.
FIG. 17 is a cross-sectional view of a flow path when the first substrate and the cover layer shown in FIGS. 15 and 16, respectively, are bonded to each other.
FIG. 18 is a bottom view showing a second surface of the first substrate shown in FIG. 1.
FIG. 19 is a plan view of a second flow path pattern formed on the cover layer shown in FIG. 1.
FIG. 20 is a cross-sectional view of a flow path when the first substrate and the cover layer shown in FIGS. 18 and 19, respectively, are bonded to each other.
FIGS. 21 to 26 are cross-sectional views of a flow path formed between the first substrate and the cover layer according to various embodiments.

### DETAILED DESCRIPTION

Embodiments of the present disclosure will now be described more fully hereinafter with reference to the accompanying drawings. The embodiments may, however, be provided in different forms, and the descriptions herein should not be construed as limiting. Some of components of the embodiments that are not directly associated with the description or are well known in the art may not be provided to more concisely describe embodiments of the present disclosure.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meanings such as "apart from" or "set aside from" or "offset from" and any other suitable equivalents as would be appreciated and understood by those of ordinary skill in the art. The terms "face" and "facing" may mean that a first object may directly or indirectly oppose a second object. When a third object is between a first and second object, the first and second objects may be understood as being indirectly opposed to one another, although still facing each other.

The terms "about" or "approximately," as used herein, are inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments of the present disclosure will be described in detail with reference to the accompanying drawings.

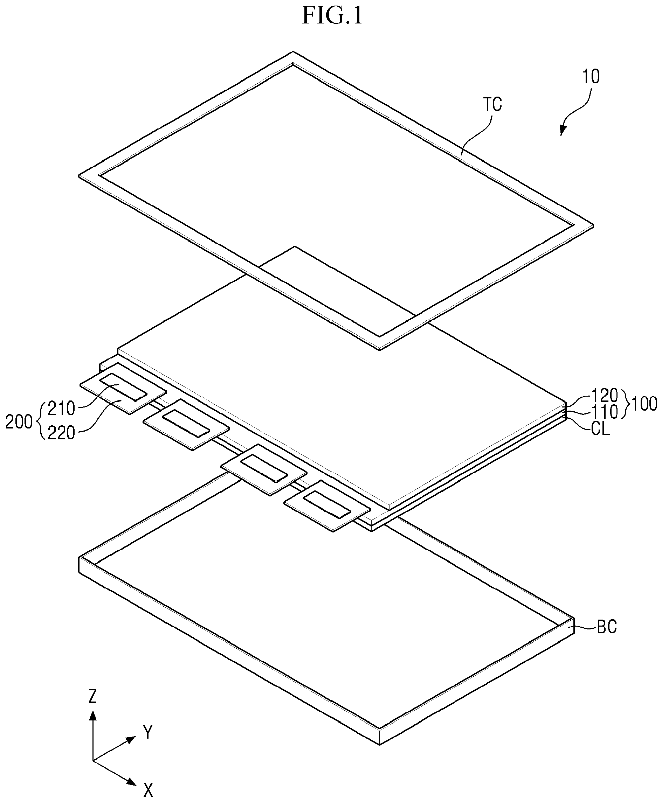

FIG. 1 is an exploded, perspective view of a display device according to an embodiment of the invention.

Referring to FIG. 1, a display device 10 includes a top cover TC, a bottom cover BC, a display panel 100, a cover layer CL, and a data driver 200.

As used herein, the terms "on", "top", and "upper surface" refer to the side of a first substrate 110 of the display panel 100 on which the second substrate 120 is disposed (e.g., the direction indicated by the third direction or the z-axis direction), and the terms "under", "bottom", and "lower surface" refer to the opposite side of the first substrate 110 of the display panel 300 where the cover layer CL is disposed (e.g., the opposite direction to the third direction or the z-axis direction). As used herein, the terms "left," "right," "upper", and "lower" sides indicate relative positions when the display panel 100 is viewed from the top. For example, the "left side" refers to the side indicated by the first direction (e.g., the x-axis direction), the "right side" refers to the opposite side to the side indicated by the first direction (e.g., the x-axis direction), the "upper side" refers to the side indicated by the second direction (e.g., the y-axis direction), and the "lower side" refers to the opposite side to the side indicated by the second direction (e.g., the y-axis direction).

The top cover TC may be disposed to cover the edges of the upper surface. The top cover TC may cover a non-display area of the display panel 100 except a display area of the display panel 100. The bottom cover BC may be disposed under the cover layer CL. The bottom cover BC may be disposed so that the flexible films 220 cover the cover layer CL when the flexible films 220 are bent and the driving circuits 210 are disposed under the cover layer CL.

In the embodiment shown in FIG. 1, the length of the bottom cover BC in the second direction (e.g., the y-axis direction) may be substantially equal to or greater than the length of the cover layer CL in the second direction (e.g., the y-axis direction). The top cover TC and the bottom cover BC may be made of plastic or metal or may include both plastic and metal.

The display panel 100 may have a rectangular shape when viewed from the top. For example, the display panel 100 may have a rectangular shape having longer sides in a first direction (e.g., the x-axis direction) and shorter sides in a second direction (e.g., the y-axis direction) when viewed from the top, as shown in FIG. 1. The corners at where the shorter sides in the first direction (e.g., the x-axis direction) meet the longer sides in the second direction (e.g., the y-axis direction) may be a right angle or may be rounded with a curvature (e.g., with a predetermined curvature). The shape of the display panel 100 when viewed from the top is not limited to a rectangular shape and may be a different polygonal shape, a circular shape, or an elliptical shape.

A first surface of the first substrate 110 and a second surface of the second substrate 120 may face each other.

A second surface of the first substrate 110 and a first surface of the cover layer CL may face each other. The first substrate 110 and the cover layer CL may be bonded to each other. A flow path, through which a working fluid can be circulated, may be formed between the first substrate 110 and the cover layer CL. The first substrate 110 and the cover layer CL may be bonded to each other by a double-sided adhesive film or an adhesive or by other methods, such as by welding or soldering. The structure of the flow path will be described in more detail later.

The cover layer CL may be implemented as a multilayer structure. Some layers of the cover layer CL may include a plurality of graphite layers or a plurality of metal layers formed in the first direction (e.g., the x-axis direction) and the second direction (e.g., the y-axis direction). In such an embodiment, the heat generated by the display panel 100 can be diffused in the first direction (e.g., the x-axis direction) and the second direction (e.g., the y-axis direction), and thus, the heat can be more effectively discharged.

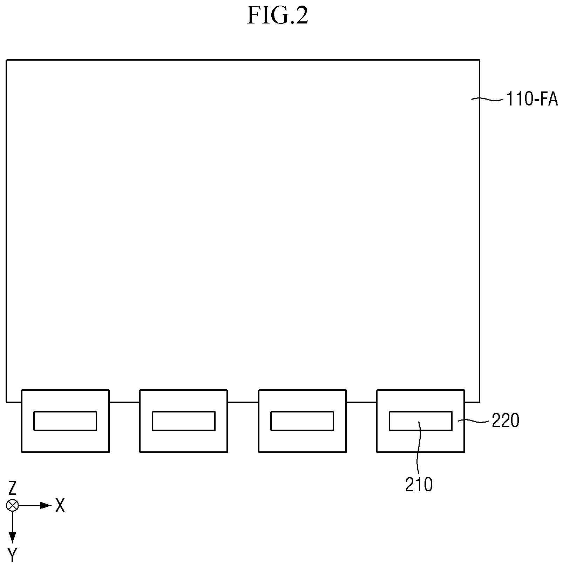

FIG. 2 is a bottom view showing the upper surface of the display panel when the flexible films in FIG. 1 are unfolded.

Although a flat display panel 100 is shown in FIG. 2, this is merely an example. The display panel 100 may include a curved portion that is bent to have a curvature (e.g., to have a predetermined curvature).

Referring to FIGS. 1 and 2, the display panel 100 may include the first substrate 110 and the second substrate 120. The second substrate 120 may be disposed to face a first surface 110-FA of the first substrate 110. The first substrate 110 and the second substrate 120 may be rigid or flexible. The first substrate 110 may be made of glass or plastic. The second substrate 120 may be formed of glass, plastic, an encapsulation film, or a barrier film. In some embodiments, the second substrate 120 may be omitted. When the first substrate 110 and the second substrate 120 are made of a plastic, the plastic may be polyethersulphone (PES), polyacrylate (PA), polyacrylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or combinations thereof. The encapsulation film or the barrier film may be a stack of multiple inorganic layers.

The display panel 100 may be an organic light-emitting display panel using (e.g., emitting light via) an organic light-emitting diode including a first electrode, an organic emission layer, and a second electrode, an inorganic light-emitting display panel using an inorganic light-emitting diode including a first electrode, an inorganic semiconductor layer, and a second electrode, or a quantum-dot light-emitting display panel including a quantum-dot light-emitting diode including a first electrode, a quantum-dot emission layer, and a second electrode.

In the following description, an organic light-emitting display panel that includes a first substrate and a second substrate and a thin-film transistor layer, an emission material layer, a light conversion layer, and a color filter layer disposed on the first substrate will be described as the display panel 100 as an example. In such an embodiment, the first substrate 110 is a thin-film transistor substrate on which a thin-film transistor layer TFTL, an emission material layer EML, and an encapsulation layer SIL are formed. The second substrate 120 is a color filter substrate on which a light conversion layer QDL and a color filter layer CFL are formed.

In some embodiments, the second substrate 120 of the display panel 100 may be omitted, and a thin-film encapsulation layer may be disposed on the emission material layer EML. The light conversion layer QDL and the color filter layer CFL may be disposed on the thin-film encapsulation layer.

One side of each of the flexible films 220 may be attached to the first surface of the first substrate 110 of the display panel 100. For example, because the first substrate 110 is larger than the second substrate 120, one side of the first substrate 110 may not covered (or entirely covered) by the second substrate 120 and may be exposed (or partially exposed). The flexible films 220 may be attached to the side of the exposed first substrate 110 that is not covered by the second substrate 120. Each of the flexible films 220 may be attached to the first surface of the first substrate 110 and a surface of the respective driving circuit 210 by using an anisotropic conductive film.

Each of the flexible films 220 may be a tape carrier package or a chip-on-film. The flexible films 220 may be bent under the first substrate 110 such that the driving circuits 210 may be located on the lower surface of the cover layer CL. Although FIG. 1 illustrates an embodiment in which four flexible films 220 are attached on the first substrate 110 of the display panel 100, the number of the flexible films 220 is not limited to four.

The driving circuits 210 may be disposed on the surfaces of the flexible films 220, respectively. Each of the driving circuits 210 may be implemented as an integrated circuit (IC). Each of the driving circuits may be connected to a signal line and connected to pixels disposed in the display area of the display panel 100.

Pixels may be disposed in areas of the display panel 100 defined by, for example, data lines and scan lines.

A control circuit board and a power supply circuit may be additionally adhered to one surface of the flexible films 220.

The control circuit board and power supply circuit are electrically connected to the flexible films 220. The power supply circuit may generate voltages for driving the display panel 100 from a main power source applied from the system circuit board and may supply the voltages to the display panel 100. For example, the power supply circuit may generate a high-potential voltage, a low-potential voltage, and an initialization voltage for driving the organic light-emitting elements and may supply the generated voltages to the display panel 100. In addition, the power supply circuit may generate and supply driving voltages for driving the driving circuit and the like. The power supply circuit may be implemented as an integrated circuit. In some embodiments, the power supply circuit may be disposed on a power supply circuit board formed separately from the control circuit board. The power supply circuit board may be a flexible printed circuit board or a printed circuit board.

Although the display device 10 is shown in FIG. 1 as being a middle- or large-sized display device including the plurality of driving circuits 210, this is merely an example. For example, the display device 10, according to other embodiments of the present disclosure, may be a small-sized display device including a single driver circuit 210. Examples of the middle- or large-sized display devices include monitors, and television sets, etc., and examples of small-sized display devices include smart phones, tablet PCs, etc.

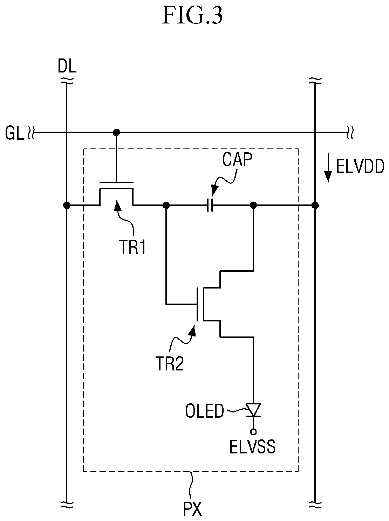

FIG. 3 is an equivalent circuit diagram of a pixel of the display panel.

As shown in FIG. 3, each of the pixels PX includes an organic light-emitting diode OLED and circuitry for controlling the organic light-emitting diode OLED. The circuitry includes a first transistor TR1, a second transistor TR2, and a capacitor CAP. The equivalent circuit of the pixel PX is not limited to that shown in FIG. 3 and may be suitably modified.

The first transistor TR1 includes a control electrode connected to a gate line GL, an input electrode connected to a data line DL, and an output electrode. The first transistor TR1 outputs a data signal applied to the data line DL in response to a gate signal applied to the gate line GL.

The capacitor CAP includes a first electrode connected to the first transistor TR1 and a second electrode for receiving a first supply voltage ELVDD. The capacitor CAP is charged with the voltage corresponding to the data signal received from the first transistor T1.

The second transistor TR2 includes a control electrode connected to the output electrode of the first transistor TR1 and the first electrode of the capacitor CAP, an input electrode for receiving the first supply voltage ELVDD, and an output electrode. The output electrode of the second transistor TR2 is connected to the organic light-emitting diode OLED. The second transistor T2 controls the driving current flowing in the organic light-emitting diode OLED in response to the voltage stored in the capacitor CAP.

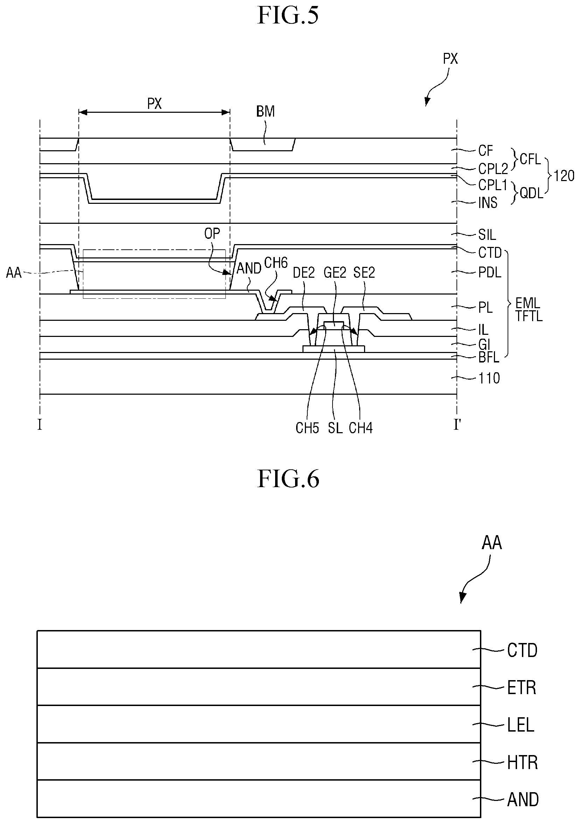

The organic light-emitting diode OLED includes a first electrode AND (see, e.g., FIG. 5) connected to the second transistor TR2 to receive the first supply voltage ELVDD and a second electrode CTD (see, e.g., FIG. 5) to receive a second supply voltage ELVSS. In addition, the organic light-emitting diode OLED includes a light-emitting layer LEL (see, e.g., FIG. 6) disposed between the first electrode AND and the second electrode CTD. The organic light-emitting diode OLED emits light during the turn-on period of the second transistor TR2.

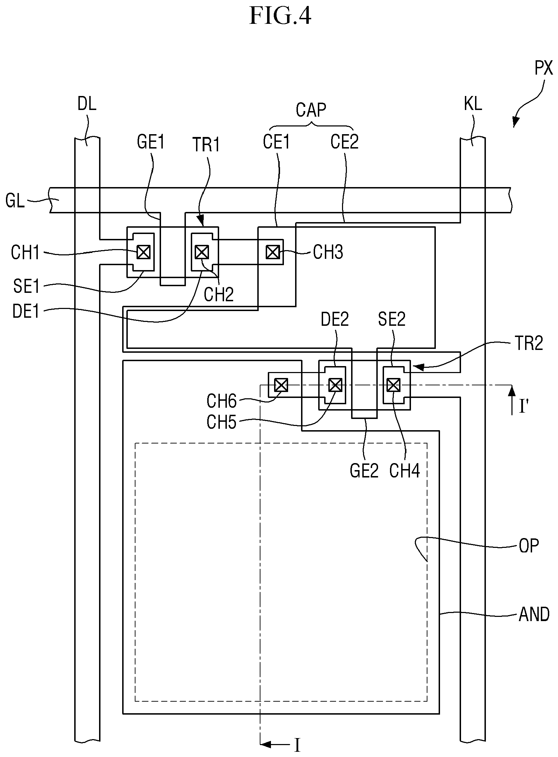

FIG. 4 is a view showing a layout of a pixel, and FIG. 5 is a cross-sectional view taken along the line I - I' of FIG. 4.

Hereinafter, the organic light-emitting display panel will be described in more detail with reference to FIGS. 4 and 5.

The display panel 100 includes a first substrate 110, a buffer layer BFL, signal lines GL and DL, and pixels PX on one plane. Depending on the type of display panel 100, the configuration of the first substrate 110, the buffer layer BFL, the signal lines GL and DL, and the pixels PX may be suitably altered.

The display panel 100 may include the first substrate 110, the thin-film transistor layer TFTL, the emission material layer EML, and the second substrate 120.

The buffer layer BFL is disposed on one surface (e.g., an upper surface) of the first substrate 110.

The buffer layer BFL prevents impurities in the first substrate 110 from entering the pixel PX during the fabrication process. For example, the buffer layer BFL can prevent diffusion of impurities into a semiconductor layer SL of the pixel PX. Impurities may be introduced from the outside or may be generated by thermal decomposition of the first substrate 110. The impurities may be gas or sodium discharged from (or emitted by) the first substrate 110. In addition, the buffer layer BFL blocks moisture from flowing into the pixel PX from the outside.

The signal lines GL and DL and the pixel PX are disposed on the buffer layer BFL.

The thin-film transistor layer TFTL is disposed on the buffer layer BFL. The thin-film transistor layer TFTL includes a second transistor. The semiconductor layer SL of the second transistor TR2 is disposed on the buffer layer BFL. The semiconductor layer SL may include poly silicon or amorphous silicon formed at a low temperature. In some embodiments, the semiconductor layer SL may include a metal oxide semiconductor.

The semiconductor layer SL has a channel region acting as a passage through which electrons or holes can move, and a first ion-doped region and a second ion-doped region disposed with the channel region therebetween.

A gate insulator GI is disposed on the buffer layer BFL and covers the semiconductor layer SL. The gate insulator GI includes an organic film and/or an inorganic film. In some embodiments, the gate insulator GI may include a plurality of inorganic thin films. The plurality of inorganic thin films may include a silicon nitride layer and a silicon oxide layer.

The gate line GL is disposed on the gate insulator GI. A control electrode GE1 of the first transistor T1 (hereinafter referred to as a first control electrode) and a control electrode GE2 of the second transistor T2 (hereinafter referred to as a second control electrode) are disposed on the gate insulator GI.

A first electrode CE1 of the capacitor CAP may be disposed on the gate insulator GI; however, the position of the first electrode CE1 is not limited thereto. The first electrode CE1 may be fabricated via the same photolithography process as the gate line GL. For example, the first electrode CE1 may be made of the same material as the gate line GL.

An interlayer dielectric layer IL is disposed on the gate insulator GI and covers the first control electrode GE1, the second control electrode GE2, and the first electrode CE1. The interlayer dielectric layer IL includes an organic film and/or an inorganic film. For example, the interlayer dielectric layer IL may include a plurality of inorganic thin films. The plurality of inorganic thin films may include a silicon nitride layer and a silicon oxide layer.

A data line DL and a power line KL are disposed on the interlayer dielectric layer IL. An input electrode SE1 (hereinafter referred to as a first input electrode) and an output electrode DE1 (hereinafter referred to as a first output electrode) of the first transistor TR1 are disposed on the interlayer dielectric layer IL. An input electrode SE2 (hereinafter referred to as a second input electrode) and an output electrode DE2 (hereinafter referred to as a second output electrode) of the second transistor TR2 are disposed on the interlayer dielectric layer IL. The first input electrode SE1 branches off from (e.g., is integrally formed with) the data line DL. The second input electrode SE2 branches off from the power line KL.

The second electrode CE2 of the capacitor CAP may be disposed on the interlayer dielectric layer IL; however, the position of the second electrode CE2 is not limited thereto. The second electrode CE2 may be fabricated via the same photolithography process as the data line DL and the power line KL and may be made of the same material.

The first input electrode SE1 and the first output electrode DE1 are connected to the semiconductor layer of the first transistor TR1 through a first through hole (e.g., a first opening) CH1 and a second through hole (e.g., a second opening) CH2 penetrating (or extending through) the gate insulator GI and the interlayer dielectric layer IL. The first output electrode DE1 is connected to the first electrode CE1 through a third through hole (e.g., a third opening) CH3 penetrating the interlayer dielectric layer IL. The second input electrode SE2 and the second output electrode DE2 are connected to the semiconductor layer SL of the second transistor TR2 through a fourth through hole (e.g., a fourth opening) CH4 and a fifth through hole (e.g., a fifth opening) CH5 penetrating the gate insulator GI and the interlayer dielectric layer IL. However, in another embodiment of the present disclosure, the first transistor TR1 and the second transistor TR2 may have a bottom-gate structure.

A passivation layer PL is disposed on the interlayer dielectric layer IL and covers the first input electrode SE1, the first output electrode DE1, the second input electrode SE2, and the second output electrode DE2. The passivation layer PL includes an organic film and/or an inorganic film. For example, the passivation layer PL may include an organic material to provide a flat surface (e.g., a flat upper surface).

The emission material layer EML is disposed on the thin-film transistor layer TFTL.

The emission material layer EML includes a pixel-defining film PDL and an organic light-emitting diode (OLED). The organic light-emitting diode (OLED) will be described later with reference to FIG. 6.

The pixel-defining film PDL and the organic light-emitting diode (OLED) are disposed on the passivation layer PL. The first electrode AND is connected to the second output electrode DE2 through a sixth through hole (e.g., a sixth opening) CH6 penetrating the passivation layer PL.

The first electrode AND is disposed on the passivation layer PL. The opening OP in the pixel-defining film PDL exposes the first electrode AND (e.g., exposes at least a portion of the first electrode AND).

An encapsulation layer SIL is disposed on the second electrode CTD. The encapsulation layer SIL may include a plurality of thin-film encapsulation layers. The thin-film encapsulation layers may include a silicon nitride layer and a silicon oxide layer.

The second substrate 120 is disposed on the encapsulation layer SIL. The second substrate 120 may include a light conversion layer QDL and a color filter layer CFL.

The light conversion layer QDL converts short-wavelength light, such as blue light or ultraviolet light, emitted from a light-emitting layer LEL (see, e.g., FIG. 6) into red light or green light or leaves it as blue light.

The color filter layer CFL transmits red light, green light, and blue light converted by (or emitted through) the light conversion layer QDL.

The color filter layer CFL may include a black matrix BM and color filters CF. The black matrix BM may be disposed to overlap the pixel-defining film PDL but not overlapping the pixels. The black matrix BM may include a black dye that may block light without transmitting it or may include an opaque metal material.

FIG. 6 shows a schematic cross-sectional view of an organic light-emitting diode included in a pixel PX.

Referring to FIG. 6, the organic light-emitting diode OLED may include the first electrode AND, a hole transport region HTR disposed on the first electrode AND, a light-emitting layer LEL disposed on the hole transport region HTR, an electron transport region ETR disposed on the light-emitting layer LEL, and the second electrode CTD disposed on the electron transport region ETR.

The first electrode AND is disposed on the first substrate 110 and has conductivity. The first electrode AND may be a pixel electrode or an anode electrode. The first electrode AND may be a transmissive electrode, a transflective electrode, or a reflective electrode.

When the first electrode AND is a transparent electrode, it may be made of a transparent metal oxide, such as indium tin oxide (ITO), indium zinc oxide (IZO), zinc oxide (ZnO), and indium tin zinc oxide (ITZO). When the first electrode AND is a transflective electrode or a reflective electrode, the first electrode AND may include Ag, Mg, Al, Pt, Pd, Au, Ni, Nd, Ir, Cr, or a mixture of these metals. The first electrode AND may be a single layer made of a transparent metal oxide or metal or may have a multi-layer structure made of different materials. For example, the first electrode AND may have, but is not limited to, a single-layer structure of ITO, Ag, or a mixture of metals (e.g., a mixture of Ag and Mg), a two-layer structure of ITO/Mg or ITO/MgF, or a three-layer structure of ITO/Ag/ITO.

The hole transport region HTR is disposed on the first electrode AND and injects/transports holes. The hole transport region HTR may include at least one of a hole injection layer, a hole transport layer, and an electron blocking layer.

The hole transport region HTR may have a single-layer structure made of a single material, a single-layer structure made of different materials, or a multi-layer structure including multiple layers made of different materials.

For example, the hole transport region HTR may have, but is not limited to, a single-layer structure made of different materials, or a stack structure of a hole injection layer/hole transport layer, or a hole injection layer/hole transport layer/electron blocking layer stacked sequentially from the first electrode AND.

The hole transport region HTR may be formed by a variety of methods, such as vacuum deposition, spin coating, casting, LB (Langmuir-Blodgett) technique, inkjet printing, laser printing, and laser induced thermal imaging (LITI).

When the hole transport region HTR includes the hole injection layer, the hole transport region HTR may include, but is not limited to, phthalocyanine compounds such as copper phthalocyanine; DNTPD (N,N'-diphenyl-N,N'-bis-[4-(phenyl-m-tolyl-amino)-phenyl]-biphenyl-4,4'-diamine); m-MTDATA (4,4',4"-tris(3-methylphenylphenylamino) triphenylamine); TDATA (4,4'4"-tris(N,N-diphenylamino)triphenylamine); 2TNATA (4,4',4"-tris{N,-(2-naphthyl)-N-phenylamino}-triphenylamine); PEDOT/PSS (poly(3,4-ethylenedioxythiophene)/poly(4-styrenesulfonate)); PANI/DBSA (polyaniline/dodecylbenzenesulfonic acid); PANI/CSA (polyaniline/camphor sulfonic acid); and PANI/PSS ((polyaniline)/poly(4-styrenesulfonate). The hole injection layer may have a thickness in a range of approximately 100 Å (10nm) to approximately 10,000 Å (1000nm). When the thickness of the hole injection layer is within the above-range, satisfactory hole injection characteristics can be obtained without a substantial increase in driving voltage.

When the hole transport region HTR includes the hole injection layer, the hole transport region HTR may include, but is not limited to, carbazole-based derivatives, such as N-phenylcarbazole and polyvinylcarbazole; fluorine-based derivatives; TPD (N,N'-bis(3-methylphenyl)-N,N'-diphenyl-[1,1-biphenyl]-4,4'-diamine); triphenylamine derivatives such as TCTA (4,4',4"-tris(N-carbazolyl)triphenylamine); NPB (N,N'-di(1-naphthyl)-N,N'-diphenylbenzidine); and TAPC (4,4'-Cyclohexylidene bis[N,N-bis(4-methylphenyl)benzenamine]). The hole transport layer may have a thickness in a range of approximately 50 Å (5nm) to approximately 2,000 Å (200nm). When the thickness of the hole transport layer is within the above-range, satisfactory hole transport characteristics can be obtained without a substantial increase in driving voltage.

The hole transport region HTR may further include a charge generating material for improving conductivity in addition to the above-listed materials. The charge generating material may be uniformly or non-uniformly dispersed in the hole transport region HTR. The charge generating material may be, for example, a p-dopant. The p-dopant may be, but is not limited to, one of a quinone derivative, a metal oxide, and a compound containing a cyano group. For example, non-limiting examples of p-dopants may include, but are not limited to, quinone derivatives, such as TCNQ (tetracyanoquinodimethane) and F4-TCNQ (2,3,5,6-tetrafluoro-tetracyanoquinodimethane), and metal oxides, such as tungsten oxide and molybdenum oxide, etc.

The light-emitting layer LEL is disposed on the hole transport region HTR. The light-emitting layer LEL may have a single-layer structure made of a single material, a single-layer structure made of different materials, or a multi-layer structure including multiple layers made of different materials.

The light-emitting layer LEL may be formed by a variety of methods, such as vacuum deposition, spin coating, casting, LB (Langmuir-Blodgett) technique, inkjet printing, laser printing, and laser induced thermal imaging (LITI).

The material of the light-emitting layer LEL is not particularly limited. For example, the light-emitting layer LEL may be made of a material that emits light and may include a fluorescent material or a phosphorescent material. In addition, the light-emitting layer LEL may include a host and a dopant.

The light-emitting layer LEL may emit light having a short wavelength, such as blue light and ultraviolet light. The peak wavelength range of blue light may be in a range of approximately 450 nm to approximately 490 nm, and the peak wavelength range of ultraviolet light may be less than approximately 450 nm.

According to another embodiment, when the light conversion layer QDL is not disposed on the light-emitting layer LEL, the light-emitting layer LEL may allow each pixel to emit blue, red, or green light and may include a host and a dopant.

The material of the host is not particularly limited and may be, for example, Alq3(tris(8-hydroxyquinolino)aluminum); CBP (4,4'-bis(N-carbazolyl)-1,1'-biphenyl); PVK (poly(n-vinylcarbazole); poly(n-vinylcarbazole)); ADN (9,10-di(naphthalene-2-yl)anthracene); TCTA (4,4',4"-Tris(carbazol-9-yl)-triphenylamine); TPBi (1,3,5-tris(N-phenylbenzim idazole-2-yl) benzene); 3-tert-butyl-9, 1 0-di(naphth-2-yl)anthracene (TBADN); DSA (distyrylarylene); CDBP (4,4'-bis(9-carbazolyl)-2,2"-dimethyl-biphenyl); and MADN (2-Methyl-9,10-bis(naphthalen-2-yl)anthracene).

When the light-emitting layer LEL emits red light, the light-emitting layer LEL may include, for example, a fluorescent material including PBD:(Eu(DBM)3(Phen)(tris(dibenzoylmethanato)phenanthoroline europium)) or perylene. When the light-emitting layer LEL emits red light, the dopant included in the light-emitting layer LEL may be selected from among, for example, a metal complex or an organometallic complex, such as PIQIr(acac)(bis(1-phenylisoquinoline)acetylacetonate iridium); PQIr(acac)(bis(1-phenylquinoline)acetylacetonate iridium); PQIr (tris(1-phenylquinoline) iridium; bis(1-phenylquinoline)acetylacetonate iridium(pqIr (acac)); tris(1-phenylquinoline iridium) and octaethylporphyrin platinum (PtOEP).

When the light-emitting layer LEL emits green light, the light-emitting layer LEL may include, for example, a fluorescent material including tris(8-hydroxyquinolino)aluminum (Alq3). When the light-emitting layer LEL emits green light, the dopant included in the light-emitting layer LEL may be selected from, for example, a metal complex, such as Ir(ppy)3 (fac-tris(2-phenylpyridine)iridium), a metal complex, or an organometallic complex.

When the light-emitting layer LEL emits blue light, the light-emitting layer LEL may include a fluorescent material including one selected from the group consisting of: spiro-DPVBi, spiro-6P, DSB(distyryl-benzene), DSA(distyryl-arylene), PFO(polyfluorene) polymer and PPV (poly(p-phenylene vinylene) polymer. When the light-emitting layer LEL emits blue light, the dopant included in the light-emitting layer LEL may be selected from, for example, a metal complex, such as (4,6-F2ppy)2Irpic, or an organometallic complex.

The electron transport region ETR is disposed on the light-emitting layer LEL and injects/transports electrons. The electron transport region ETR may include, but is not limited to, an electron transport layer and an electron injection layer.

The electron transport region ETR may have a stack structure of an electron transport layer/electron injection layer sequentially stacked from the light-emitting layer LEL. In addition, it may have, but is not limited to, a single-layer structure in which two or more layers (or materials) are mixed.

The electron transport region ETR may be formed by a variety of methods, such as vacuum deposition, spin coating, casting, LB (Langmuir-Blodgett) technique, inkjet printing, laser printing, and laser induced thermal imaging (LITI).

When the electron transport region ETR includes an electron transport layer, the electron transport region ETR may include, but is not limited to, Alq3 (Tris(8-hydroxyquinolinato)aluminum),TPBi (1,3,5-Tri(1-phenyl-1H-benzo[d]imidazol-2-yl)phenyl),BCP (2,9-Dimethyl-4,7-diphenyl-1,10-phenanthroline),Bphen(4,7-Diphenyl-1,10-phenanthroline),TAZ (3-(4-Biphenylyl)-4-phenyl-5-tert-butylphenyl-1,2,4-triazole),NTAZ (4-(Naphthalen-1-yl)-3,5-diphenyl-4H-1,2,4-triazole);tBu-PBD (2-(4-Biphenylyl)-5-(4-tert-butylphenyl)-1,3,4-oxadiazole),BAlq (Bis(2-methyl-8-quinolinolato-N1,O8)-(1,1'-Biphenyl-4-olato)aluminum), Bebq2 (berylliumbis(benzoquinolin-10-olate)),ADN (9,10-di(naphthalene-2-yl)anthracene), or a mixture thereof. The electron transport layer may have a thickness in a range of approximately 100 Å to approximately 1,000 Å. With the thickness of the electron transport layer is within the above-range, satisfactory electron transport characteristics can be obtained without a substantial increase in driving voltage.

When the electron transport region ETR includes the electron injection layer, the electron transport region ETR may be made of, but is not limited to, a lanthanide metal, such as LiF, LiQ (lithium quinolate), LizO, BaO, NaCl, CsF and Yb, or a metal halide, such as RbCl and RbI. The electron injection layer may also be made of a mixture of an electron transport material and an insulating organometal salt. The organometal salt may be a material having an energy band gap of approximately 4 eV or more. The organic metal salt may include, for example, metal acetate, metal benzoate, metal acetoacetate, metal acetylacetonate, or metallic stearate. The electron injection layer may have a thickness in a range of approximately 1 Å (0.1nm) to approximately 100 Å (10nm). When the thickness of the electron injection layer is within the above-range, satisfactory electron injection characteristics can be obtained without a substantial increase in driving voltage.

The second electrode CTD is disposed on the electron transport region ETR and may be made of a metal or an alloy having a low work function, or an electrically conductive compound or a mixture thereof. The second electrode CTD may be a common electrode or a cathode electrode.

The second electrode CTD may be a transmissive electrode, a transflective electrode, or a reflective electrode. When the second electrode CTD is a transmissive electrode, the second electrode CTD may include Li, Ca, LiF/Ca, LiF/Al, Al, Mg, Ag, or a compound or mixture thereof (e.g., a mixture of Ag and Mg). The second electrode CTD may include an auxiliary electrode. The auxiliary electrode may include a transparent metal oxide, such as indium tin oxide (ITO), indium zinc oxide (IZO), zinc oxide (ZnO), and indium tin zinc oxide (ITZO). When the second electrode CTD is a transflective electrode or a reflective electrode, the second electrode CTD may include Ag, Mg, Al, Pt, Pd, Au, Ni, Nd, Ir, Cr, Li, Ca, LiF/ Ca, LiF/Al, or a compound or mixture thereof (e.g., a mixture of Ag and Mg). In some embodiments, the second electrode CTD may have a multi-layer structure including a transparent metal oxide formed of indium tin oxide (ITO), indium zinc oxide (IZO), zinc oxide (ZnO), indium tin zinc oxide (ITZO), or the like.

When the organic light-emitting diode OLED is used in a top-emission display device, the first electrode AND may be a reflective electrode and the second electrode CTD may be a transmissive electrode or a transflective electrode. When the organic light-emitting diode OLED is used in a bottom-emission display device, the first electrode AND may be a transmissive electrode or a transflective electrode and the second electrode CTD may be a reflective electrode.

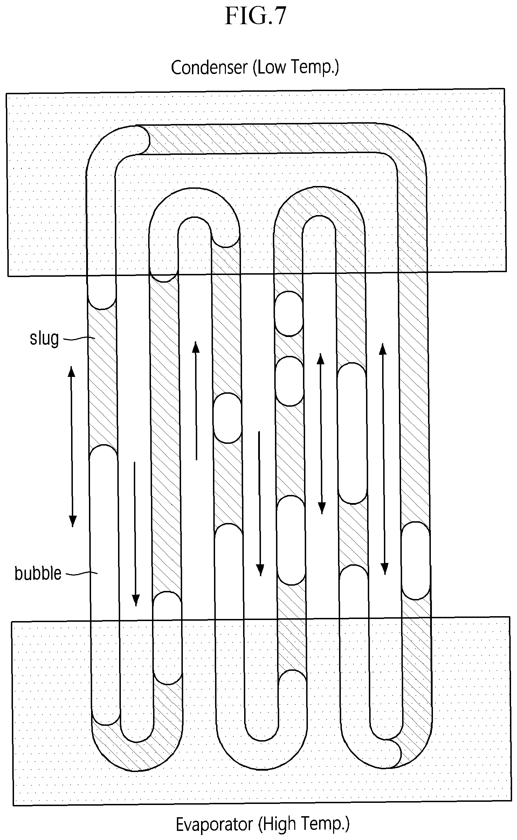

FIGS. 7 to 9 illustrate how a pulsating heat pipe works.

Referring to FIG. 7, a pulsating heat pipe, according to an embodiment, is implemented as a closed loop in which a thin pipe is bent several times like a capillary loop, with both ends of the capillary being connected to each other. The capillary may be a thin pipe having an inner diameter of approximately 3 mm or less.

An evaporator and a condenser are located at both ends of the capillary bundle, respectively. Slugs, which are the working fluid, and steam bubbles are alternately arranged in the capillary bundle. The working fluid enclosed in the thin pipe is formed as liquid plugs (slugs) and vapor bubbles by the surface tension effect and is distributed in the axial direction of the capillary.

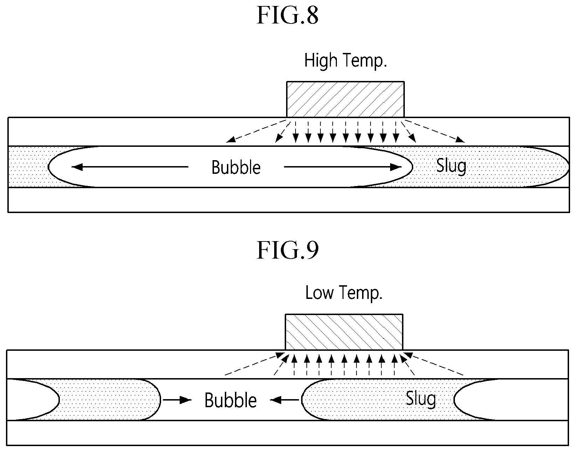

It can be seen from FIG. 8 that as the heat of the evaporator is transferred to the working fluid as latent heat of evaporation, the working fluid absorbs the external heat and evaporates, and bubbles expand due to the evaporation pressure.

It can be seen from FIG. 9 that as the working fluid is condensed in the condenser and the bubbles are contracted by the condensation pressure when the working fluid releases the heat.

As such, when there is a temperature difference between the evaporator and the condenser, the working fluid evaporates on the high-temperature side and condenses on the low-temperature side, and the difference between the evaporation pressure and the condensing pressure at both ends (e.g., opposite ends) causes a reciprocating pulsating flow of the working fluid. As a result, the heat is transferred from the high-temperature side to the low-temperature side and is then discharged to the outside as latent heat of condensation.

According to this principle, in FIG. 7, when there is a temperature difference between the evaporator and the condenser, the working fluid evaporates on the high-temperature side and condenses on the low-temperature side. That is to say, the difference between the evaporation pressure and the condensation pressure at both ends causes a reciprocating flow in the form of pulsation of the slug-train unit composed of the liquid slug and the vapor bubble inside the pipe to transfer the heat from the evaporator to the condenser.

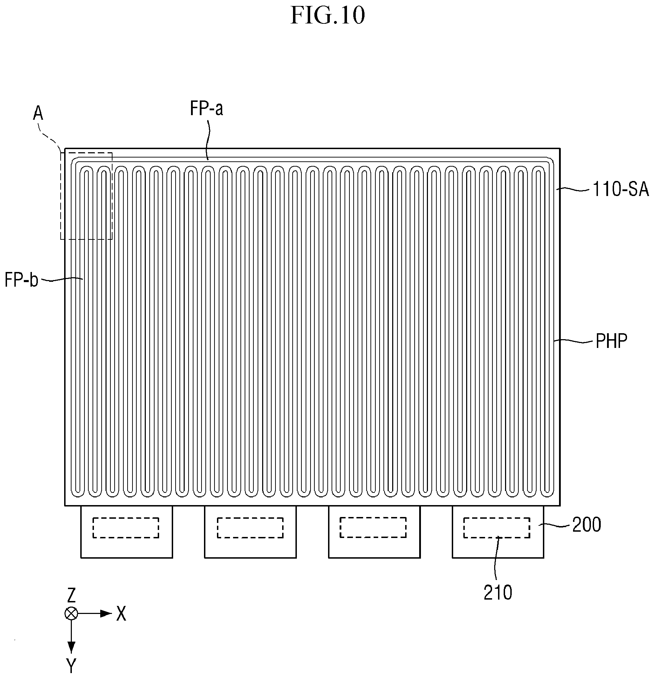

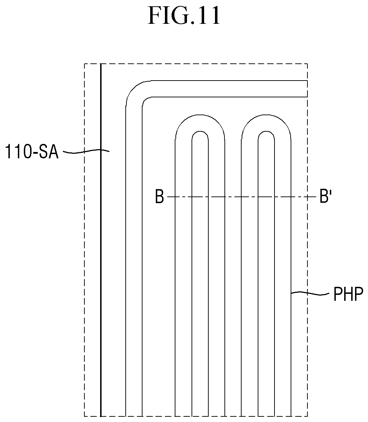

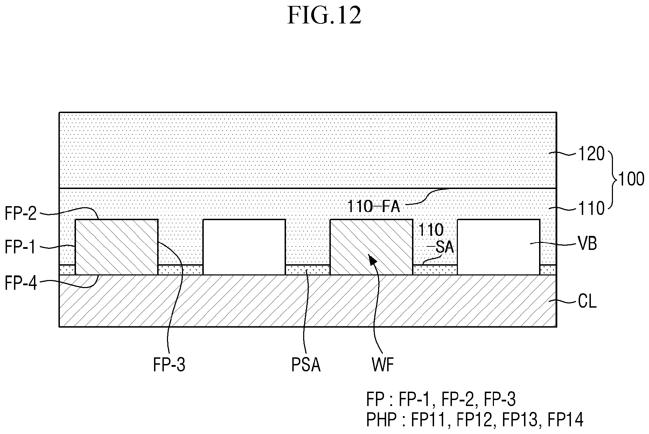

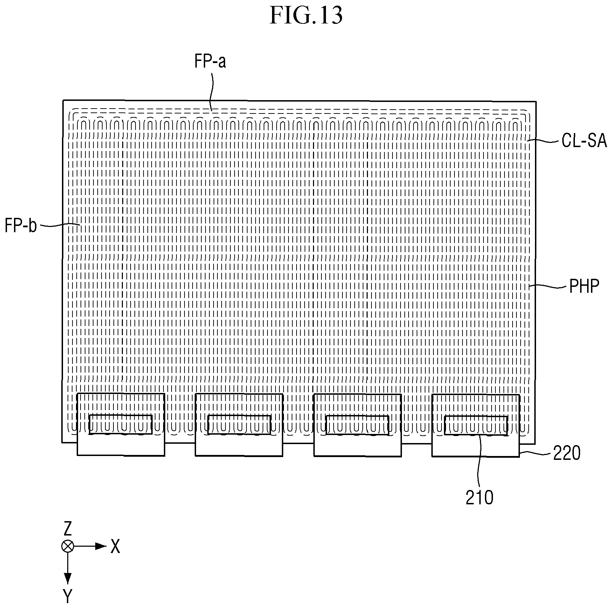

FIG. 10 is a bottom view showing the lower surface of a display panel when the flexible films shown in FIG. 1 are unfolded. FIG. 11 is an enlarged view of the part A of FIG. 10. FIG. 12 is a cross-sectional view taken along the line B-B' of FIG. 11. FIG. 13 is a bottom view showing the lower surface of the cover layer when the flexible films shown in FIG. 1 are bent under the cover layer.

Referring to FIGS. 1 and 10 to 13, the first surface 110-FA of the first substrate 110 and the second surface of the second substrate 120 may face each other.

The second surface 110-SA of the first substrate 110 and the first surface of the cover layer CL may face each other. The first substrate 110 and the cover layer CL may be bonded to each other. A flow path PHP through which a working fluid can be circulated may be formed between the first substrate 110 and the cover layer CL. An adhesive layer PSA may be formed between the first substrate 110 and the cover layer CL. The adhesive layer PSA may be implemented as a double-sided adhesive film or an adhesive or may be replaced by, for example, welding or soldering. The adhesive may be, but is not limited to, an acrylic adhesive or a silicone adhesive.

Referring to FIG. 10, a flow path pattern FP through which a working fluid can be circulated may be formed on the second surface 110-SA of the first substrate 110. The flow path pattern FP may be described as a linear flow path pattern.

The flow path pattern FP is a single channel in the form of a closed loop. It may be formed in a zigzag pattern.

The flow path pattern FP may include one horizontal portion FP-a and a plurality of vertical portions FP-b (when viewed in a plan view).

The horizontal portion FP-a extends horizontally in the direction in which the driving circuits 210 are arranged, and the vertical portions FP-b extend perpendicularly to the horizontal portion FP-a. In other words, the vertical portions FP-b extend perpendicularly to the direction in which the driving circuits 210 are extended. The vertical sections can alternately be described as comprising a series of adjacent linear channel portions so that the flow path goes backwards and forwards between the side of the substrate adjacent to the driving circuits 210 and the opposite side of the substrate. Alternatively stated, the flow path pattern FP maps out a boustrophedon path across the substrate. The first and last arms of the path are joined by a horizontal portion FP-a extending across the substrate.

The flow path pattern FP may be formed by, for example, cleaning the second surface 110-SA of the first substrate 110, made of a glass substrate, and then applying photoresist onto the first substrate 110. The photoresist is exposed to light via an exposure process using a mask. In doing so, the photoresist is divided into exposed portions and unexposed portions.

A developing process is carried out to selectively remove the exposed or unexposed portions of the photoresist. Subsequently, the first substrate 110 is etched to a depth (e.g., a predetermined depth) via an etching process by using the remaining photoresist pattern as a mask to form a single channel having the closed loop, and then, the remaining photoresist is removed.

As described above, according to an embodiment of the present disclosure, the substrate of the display panel is utilized as (or to form) the flow path so that heat dissipation effects can be achieved by the flow path without substantially increasing the overall thickness of the display panel.

Referring to FIG. 12, the flow path pattern FP is formed as concave grooves having a width and height (or depth) on (or in or from) the second surface 110-SA of the first substrate 110 and has a rectangular cross-sectional shape in FIG. 12. By forming a mask used for exposing the photoresist in various ways, the cross-section of the flow path may be formed in various polygonal shapes, such as ellipses, circles, squares, hexagons, and triangles.

The width of the flow path has a size that can effectively generate capillary force, and the height is smaller than the thickness of the first substrate 110. The flow path pattern FP may have a width in a range of approximately 1 mm to approximately 5 mm and a height in a range of approximately 0.5 mm to approximately 5 mm, but the present disclosure is not limited thereto. The width and height of the flow path pattern FP may be changed.

When the flow path pattern FP is formed in a rectangular shape as shown in FIG. 12, a first surface (e.g., a first side surface) FP-1, a second surface (e.g., a bottom surface) FP-2, and a third surface (e.g., a second side surface) FP-3 of the rectangular shape are formed on the first substrate 110 while a fourth surface (e.g., a top surface) FP- 4 is formed by the cover layer CL bonded to the first substrate 110. For example, the flow path pattern FP of the first substrate 110 is in contact with the cover layer CL to form (or to close) the flow path PHP (see, e.g., FIG. 10).

A working fluid WF may be introduced into the flow path PHP in a vacuum state. Accordingly, the working fluid WF may be observed in some cross sections of the flow path PHP while the vacuum bubbles VB may be observed in some other cross sections of the flow path PHP shown in FIG. 12. The working fluid may occupy approximately 30% to 60% of the volume of the flow path PHP. If the working fluid occupies approximately 30% or less of the volume of the flow path PHP, the amount of heat transfer medium (working fluid) is insufficient, and thus, the heat transfer efficiency may decrease. If the working fluid occupies approximately 60% or more of the volume of the flow path PHP, the space in which the working fluid can pulsate is insufficient, and thus, the heat transfer efficiency may decrease. A variety of materials may be used as the working fluid. For example, water, ethanol, ammonia, acetone, R-134a, and HFC-type fluid, which are fluids that can change phase, may be used. Among them, water and ethanol have a relatively high heat capacity and can transfer a large amount of heat.

Referring to FIG. 13, the flexible films 220 are bent toward the second surface CL-SA, which is the lower portion of the cover layer CL, and the second surfaces of the flexible films 220 are brought into contact with the second surface CL-SA of the cover layer CL. In addition, the driving circuits 210 disposed on the flexible films 220 are disposed on the second surface CL-SA of the cover layer CL.

As can be seen from FIG. 13, the driving circuits 210 are arranged in the first direction (e.g., the x-axis direction) while the flow path PHP are mostly arranged in the second direction (e.g., the y-axis direction). For example, a plurality of vertical portions FP-b of the flow path PHP may be perpendicular to the direction in which the driving circuits 210 are arranged. One horizontal portion FP-a of the flow path PHP may be parallel to the direction in which the driving circuits 210 are arranged. In addition, the one horizontal portion FP-a of the flow path PHP may be located in (or may extend through) the condenser of the flow path PHP.

A portion of the flow path PHP close to the driving circuits 210 works as the evaporator of the heat pipe and absorbs heat dissipated from the driving circuits. A portion of the flow path PHP far from the driving circuits 210 works as the condenser and discharges the heat transferred from the evaporator through the working fluid to the outside.

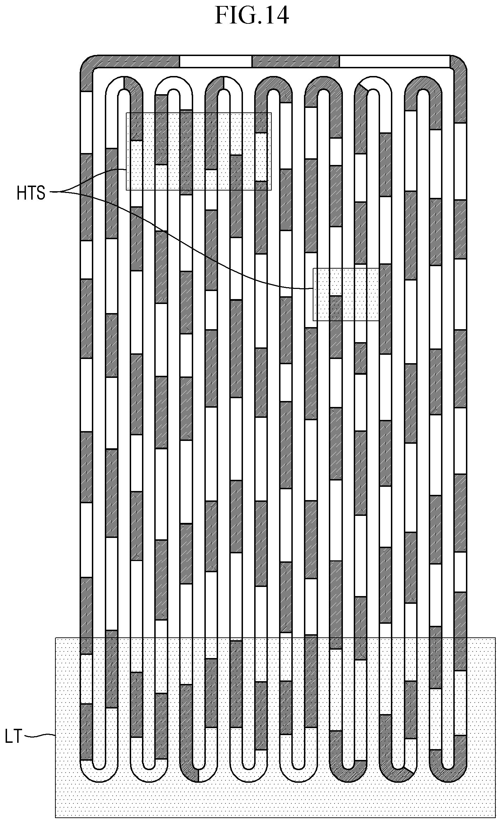

FIG. 14 is a view showing an example of a flow path having a plurality of evaporators.

Although the flow path PHP has two evaporators HTS in the embodiment shown in FIG. 14, the size, position, and number of the evaporators HTS are not limited thereto.

As shown in FIG. 14, one or more evaporators HTS may be created when the display panel 100 is driven. One or more evaporators HTS may be generated at any location including the central portion of the display panel 100. For example, when an ice hockey game is displayed on the display panel, a relatively bright ice field area is displayed at the same location and relatively dark spectator seats are displayed at the same location for a while, a large amount of heat may be generated in the ice field area.

As such, when one or more evaporators HTS are created in the display panel 100, a portion that is farther from the evaporators HTS works a condenser LT and releases heat.

As described above, when heat is applied to one or more evaporators HTS, the working fluid located in the evaporators HTS expands by the endothermic reaction and the pressure increases. The working fluid at the evaporators HTS with the increased pressure induces a force to push the working fluid of the liquid phase adjacent thereto and moves it toward the condenser LT having a low pressure. The working fluid moved to the condenser LT transfers the absorbed heat to the outside. As a result, the volume of the working fluid shrinks again. The working fluid that absorbs heat at the evaporators HTS moves to the low-temperature condenser LT and releases heat and returns to the evaporators HTS along the connected flow path. The working fluid returned to the evaporators HTS absorbs heat again and expands, and accordingly, its pressure is increased. Accordingly, the working fluid moves in the opposite direction of the flow path again and reaches the condenser LT. This process is continuously repeated so that the working fluid flows as it pulsates periodically to continuously transfer heat between the evaporators HTS and the condenser LT. Therefore, it is possible to quickly make the temperature of the display panel 100 uniform by virtue of the flow path PHP. As a result, the lifetime of the display device can be extended, and non-uniformity of luminance caused by a temperature difference of the display panel can be reduced.

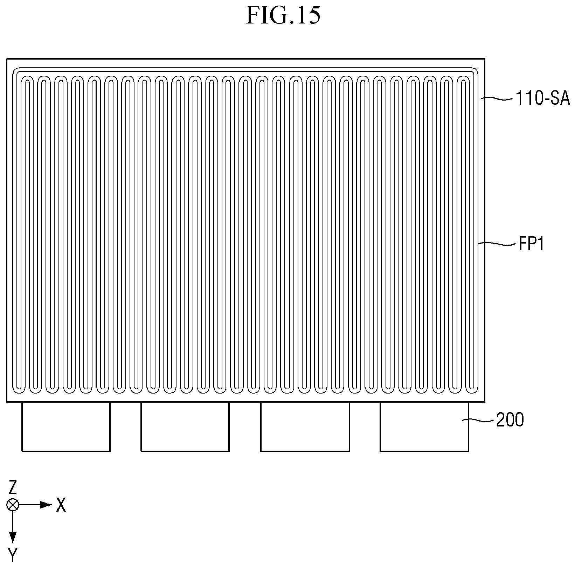

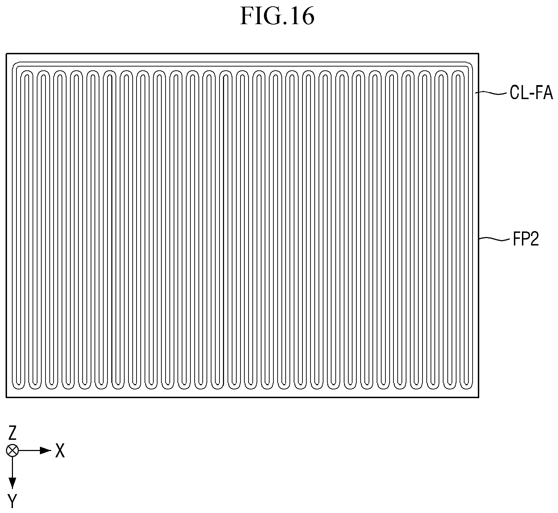

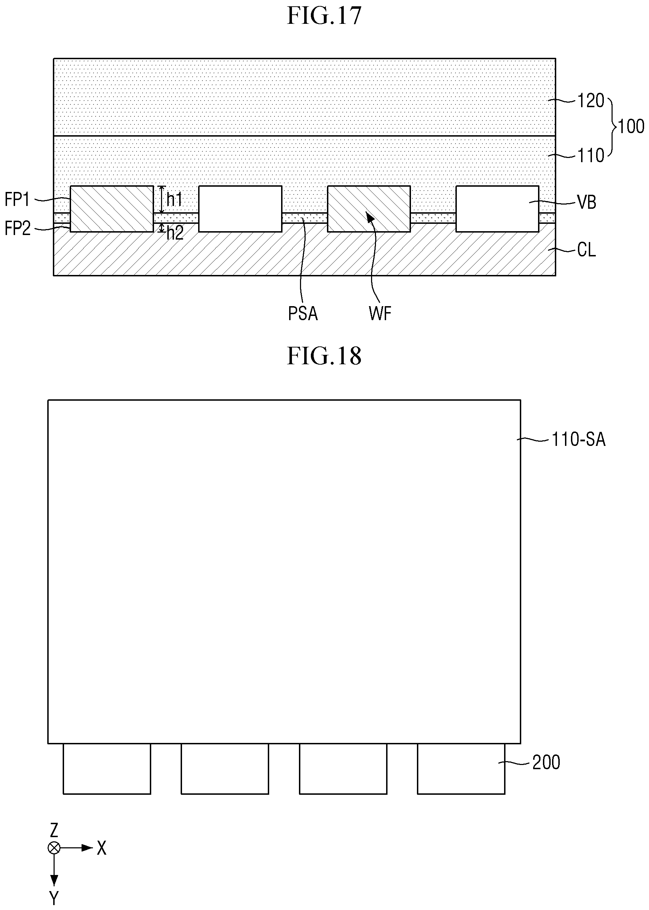

FIG. 15 is a bottom view showing a first flow path pattern formed on the first substrate shown in FIG. 1 according to an embodiment. FIG. 16 is a plan view of showing a second flow path pattern formed on the cover layer shown in FIG. 1 according to an embodiment. FIG. 17 is a cross-sectional view of a flow path when the first substrate and the cover layer shown in FIGS. 15 and 16, respectively, are bonded to each other, taken along the first direction.

The embodiment shown in FIGS. 15 to 17 is substantially identical to the embodiment shown in FIGS. 10 to 13 except that a flow path is formed with a pair of flow path patterns FP1 and FP2 engraved (or formed) to a depth (e.g., a predetermined depth) from the surfaces of the first substrate 110 and the cover layer CL facing each other, respectively; and, therefore, redundant descriptions will be omitted.

Referring to FIGS. 15 to 17, a first flow path pattern FP1 is formed on a second surface 110-SA of the first substrate 110, and a second flow path pattern FP2 is formed on a first surface CL-FA of the cover layer CL. The second surface 110-SA of the first substrate 110 and the first surface CL-FA of the cover layer CL are bonded to each other so that the first flow path pattern FP1 and the second flow path pattern FP2 form a flow path.

The depth h1 of the first flow path pattern FP1 formed on the first substrate 110 may be equal to or different from the depth h2 of the second flow path pattern FP2 formed on the cover layer CL.

The other parts of the first substrate 110 and the cover layer CL than the flow path PHP may be bonded to each other by an adhesive layer PSA.

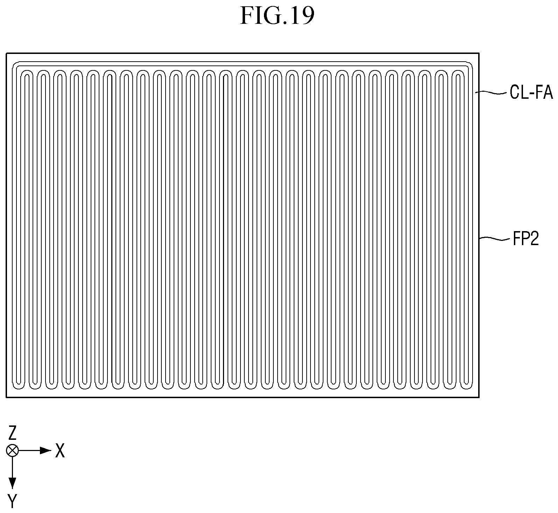

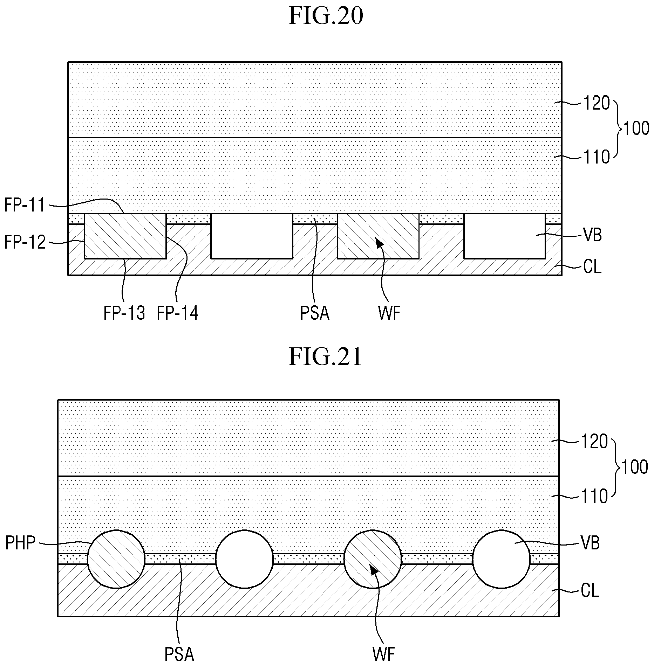

FIG. 18 is a bottom view showing a second surface of the first substrate shown in FIG. 1 according to an embodiment. FIG. 19 is a plan view of showing a second flow path pattern formed on the cover layer shown in FIG. 1 according to an embodiment. FIG. 20 is a cross-sectional view of a flow path when the first substrate and the cover layer shown in FIGS. 18 and 19, respectively, are bonded to each other, taken along the first direction.

The embodiment shown in FIGS. 18 to 20 is substantially identical to the embodiment shown in FIGS. 10 to 13 except that the first substrate 110 does not have the flow path pattern FP1 while a flow path is formed with a flow path pattern FP10 engraved to a depth (e.g., a predetermined depth) on a surface of the cover layer CL. Therefore, redundant descriptions will be omitted.

Referring to FIGS. 18 to 20, a flow path pattern FP is formed as concave grooves having width and height in a first surface CL-FA of the cover layer CL and has a rectangular shape in the cross-sectional view of FIG. 20.

When the flow path pattern FP is formed in a rectangular shape as shown in FIG. 20, a second surface FP-12, a third surface FP-13 and a fourth surface FP-14 of the rectangular shape are formed in (or formed by) the cover layer CL while a first surface FP-11 is formed on (or formed by) the first substrate 110. That is to say, the flow path pattern FP of the cover layer CL is in contact with (e.g., is closed by) the first substrate 110 so that the flow path PHP (see, e.g., FIG. 19) is formed.

The other parts of the first substrate 110 and the cover layer CL than the flow path PHP may be bonded to each other by an adhesive layer PSA.

FIGS. 21 to 26 are cross-sectional views showing a flow path formed between the first substrate and the cover layer, taken along the first direction, according to various embodiments.

FIG. 21 is a modification of the embodiment shown in FIG. 17. While the cross section of the flow path shown in FIG. 17 has a rectangular shape, the cross section of the flow path shown in FIG. 21 has a circular shape.

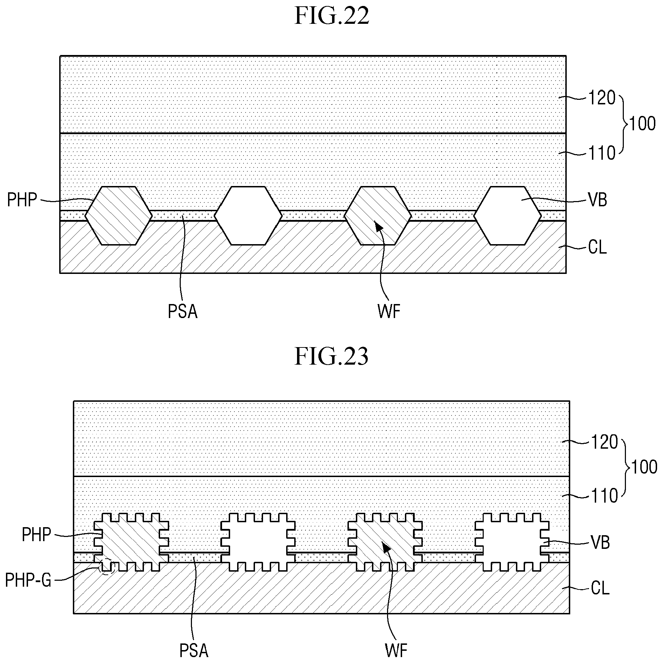

FIG. 22 is another modification of the embodiment shown in FIG. 17. While the cross section of the flow path shown in FIG. 17 has a rectangular shape, the cross section of the flow path shown in FIG. 22 has a hexagonal shape.

The cross section of the flow path may be formed in a variety of polygonal shapes, such as an ellipse, circle, square, hexagon, and triangle, as well as in a circular or hexagonal shape as shown in, for example, FIGS. 21 and 22.

As shown in FIGS. 23 to 26, at least a part of the inner circumferential surface of a flow path PHP may have protrusions to increase the contact area with a working fluid WF.

The protrusions PHP-G may be formed by grooves repeatedly formed along the inner circumferential surface of the flow path PHP. The protrusions PHP-G are extended along the longitudinal direction of the flow path PHP. When the protrusions PHP-G are repeatedly formed along the circumference of the flow path PHP, the heat dissipation area of the flow path PHP can be increased. Accordingly, the amount of heat transferred to the working fluid WF can be increased, and accordingly, the working fluid can be circulated more stably and reliably.

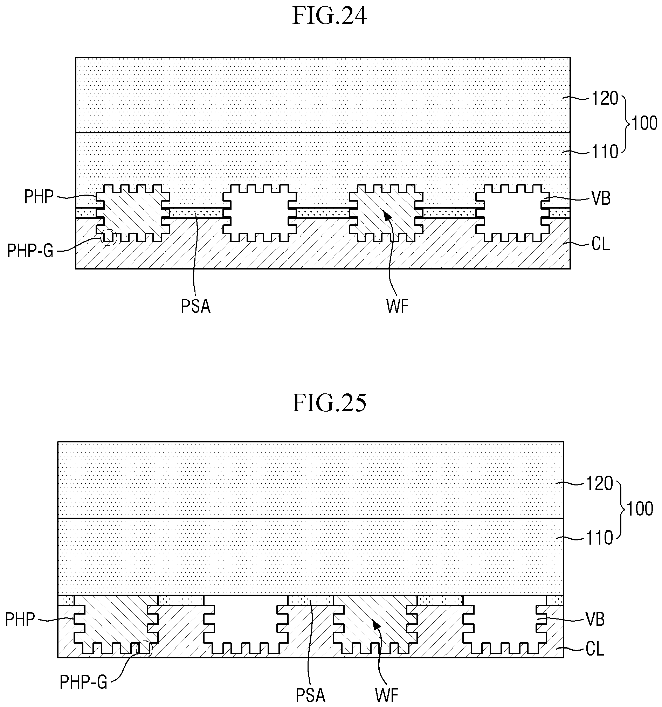

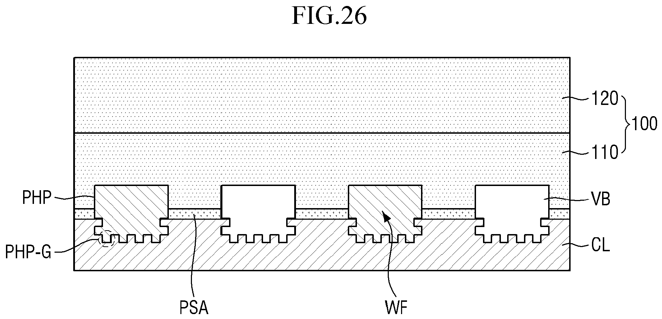

The protrusions PHP-G may be formed on the entire inner circumferential surface of the flow path PHP, as shown in FIGS. 23 and 24, or may be formed on a part of the cross section of the flow path PHP as shown in FIGS. 25 and 26.

Referring to FIGS. 25 and 26, no protrusion PHP-G is formed in a flow path of the first substrate 110 but protrusions are formed only in a flow path of the cover layer CL. An additional process is required to form the protrusions PHP-G. When the protrusions PHP-G are formed on the first substrate 110, heat generated during the additional process may deteriorate the display panel 100. For this reason, the protrusions PHP-G may be formed only on the cover layer CL so that the first substrate 110 may not be deteriorated by heat generated during the additional process and to increase the surface area of the cross section of the flow path PHP.

However, aspects and features of the present disclosure are not limited to those set forth herein. The invention is defined by the claims.

## Claims

1. A display device comprising:
a display panel (100) comprising a first substrate (110) having a pixel area; and
a cover layer (CL) facing a rear surface of the first substrate (110), the front surface of the cover layer (CL) being bonded to the rear surface of the first substrate (110);
wherein a flow path pattern defining a flow path is formed in at least one of the rear surface of the first substrate (110) and the front surface of the cover layer (CL).

2. The display device of claim 1, wherein the flow path has a single channel in the form of a closed loop.

3. The display device of claim 2, further comprising a working fluid in the flow path.

4. The display device of claim 3, wherein the volume of the working fluid is between 30% to 60% of the volume of the flow path.

5. The display device of claim 3 or 4, wherein the working fluid is water, ethanol, ammonia, acetone, R-134a, or an HFC-type fluid.

6. The display device of any one of claims 3 to 5, wherein a cross-sectional shape of the flow path is circular, elliptical or polygonal.

7. The display device of any one of claims 3 to 6, further comprising:
a flexible film attached to a front surface of the first substrate and bent toward a rear surface of the cover layer; and
a driving circuit on the flexible film and arranged along one side of the rear surface of the cover layer.

8. The display device of claim 7, wherein the working fluid is configured to absorb heat dissipated from the driving circuit and to transfer the absorbed heat to an area away from the driving circuit along the flow path.

9. The display device of claim 8, wherein an end of the flow path overlapping with the driving circuit acts as an evaporator and an opposite end of the flow path acts as a condenser.

10. The display device of claim 9, wherein the flow path comprises a horizontal portion extending in a first direction and a plurality of vertical portions extending in a second direction perpendicular to the first direction, and
wherein the horizontal portion acts as the condenser.

11. The display device of any one of the preceding claims, wherein protrusions are formed on at least a part of an inner circumferential surface of the flow path.

12. The display device of claim 11, wherein the protrusions extend along a longitudinal direction of the flow path.

13. The display device of any one of the preceding claims, wherein the display panel further comprises a thin-film transistor layer, an emission material layer, and an encapsulation layer on the first substrate, and
wherein a light conversion layer and/or a color filter layer is on the encapsulation layer.

14. The display device of any one of the preceding claims,
wherein the rear surface of the first substrate has a first flow path pattern and the front surface of the cover layer has a second flow path pattern corresponding to the first flow path pattern.

15. The display device of claim 14, wherein protrusions are formed on an inner surface of the second flow path pattern, wherein the protrusions extend along a longitudinal direction of the second flow path pattern.
